Europäisches Patentamt

European Patent Office

Office européen des brevets

(11) Publication number: **0 228 525 B1**

# EUROPEAN PATENT SPECIFICATION

(45) Date of publication of patent specification: **08.01.92**    (51) Int. Cl.⁵: **C08L 69/00**, C08K 5/06,
//(C08L69/00,71:00)

(21) Application number: **86114973.0**

(22) Date of filing: **28.10.86**

(54) **Gamma radiation resistant carbonate polymer compositions.**

(30) Priority: **31.10.85 US 793502**

(43) Date of publication of application:
**15.07.87 Bulletin 87/29**

(45) Publication of the grant of the patent:
**08.01.92 Bulletin 92/02**

(84) Designated Contracting States:
**AT BE CH DE FR GB IT LI NL SE**

(56) References cited:
**EP-A- 0 135 802**
**EP-A- 0 152 825**
**US-A- 4 587 310**

(73) Proprietor: **THE DOW CHEMICAL COMPANY**
**2030 Dow Center Abbott Road P.O. Box 1967**
**Midland Michigan 48640-1967(US)**

(72) Inventor: **Nace, Vaughn M.**
**111 Carnation .**
**Lake Jackson Texas 77466(US)**

(74) Representative: **Casalonga, Axel et al**
**BUREAU D.A. CASALONGA - JOSSE Moras-**
**sistrasse 8**
**W-8000 München 5(DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

This invention relates to a gamma radiation resistant carbonate polymer composition wherein the polycarbonate polymer is rendered radiation resistant by the incorporation of an effective amount of one or more polyether polyols and the alkyl ethers thereof and to the use of the latter for improving the resistance to gamma radiation of a carbonate polymer composition. The invention also relates to a process for their production and to an article made therefrom.

There is a distinct need for polycarbonate moldings that are resistant to gamma radiation so that they can be sterilized without substantial loss of clarity and physical characteristics.

It is known that polyolefins can be rendered radiation resistant by the addition of benzhydrol, hydrocarbon oils, phthalic esters, and benzaldehyde acetals, as taught in U.S. Patents Nos. 4,431,497, 4,460,445; and 4,467,065.

It is also known that blends of polycarbonate resins and polyethylene terephthalate are resistant to gamma rays as disclosed in Modern Plastics, January 1984, page 104 and Plastics World, December 1983, pages 68 and 69.

The present invention is a carbonate polymer having improved gamma radiation stability due to the incorporation of one or more polyether polyols and the alkyl ethers thereof in an amount sufficient to improve the gamma radiation resistance, this effective amount having been found to be in the range of from 500 to 50,000 parts per million. A preferred range is from 2500 to 15,000 ppm and the most preferred range is from 5000 to 10,000 ppm. The composition does not contain any vinylaromatic polymer component.

The carbonate polymers employed in the present invention are advantageously aromatic carbonate polymers such as, for example, the trityl diol carbonates described in U.S. Pat. Nos. 3,036,036, 3,036,037, 3,036,038 and 3,036,039, the polycarbonates of bis-(ar-hydroxyphenyl)-alkylidenes (often called bisphenol-A type diols) including their aromatically and aliphatically substituted derivatives such as those disclosed in U.S. Pat. Nos. 2,999,835, 3,038,365, and 3,334,154, and the carbonate polymers derived from other aromatic diols such as those described in U.S. Pat. No. 3,169,121.

The polycarbonate may be derived from (1) two or more different dihydric phenols or (2) a dihydric phenol and a glycol or a hydroxy- or acid-terminated polyester or a dibasic acid. Also suitable for the practice of this invention are blends of any one of the above carbonate polymers. Also included in the term "carbonate polymer" are the ester/carbonate copolymers of the types described in U.S. Pat. Nos. 3,169,121, 4,287,787, 4,156,069, 4,260,731 and 4,105,633. The polycarbonates of bisphenol-A and derivatives, including copolycarbonates of bisphenol-A, are preferred. Methods for preparing carbonate polymers for use in the practice of this invention are well known. For example, several suitable methods are disclosed in the aforementioned patents.

The polyether polyols used in this invention are well known from U.S. patent 3,370,056.

The monoalkyl ethers and the dialkyl ethers of the foregoing polyether polyols are obtained using alkyl ethers of a polyol as the initiator for the alkylene oxides. The dialkyl ethers are made by capping the foregoing alkyl ethers with an alkyl chloride.

Usually, the polyether polyols are prepared by reacting one or more alkylene oxides such as, for example, ethylene oxide, propylene oxide or butylene oxide with one or more polyols such as, for example, glycols, triols, tetrols, pentols, sugars, and sugar alcohols. The addition polymers can be in the form of random, block, or homopolymer form. The method of preparation of these random or block copolymers are well known in the art.

A preferred polyether polyol is one having the formula

$$RO\text{-}CH_2\text{-}C(R_1)H\{O\text{-}CH_2\text{-}C(R_1)H\}_n OR$$

where R is independently hydrogen or an alkyl group of 1 to 4 carbon atoms,
$R_1$ is hydrogen, methyl or ethyl, and
n is a number having an average value of 1 to 1000.

A preferred polyether polyol is polypropylene glycol.

The following examples are presented to further illustrate the invention.

Examples 1 and 2 and Comparative Run A

Three samples were prepared by adding various amounts of a polyethylene glycol (E-8000 sold by the Dow Chemical Company) to 2000 grams of polycarbonate resin pellets followed by agitation to disperse said additive. Each sample was then extruded and chopped on a 1.5 inch (38.1 mm) single-screw extruder.

The resulting pellets were injection molded to yield test discs of 2 inch (50.8 mm) diameter by 1/8 inch (3.17 mm) thick. Each sample is listed below along with the corresponding amounts of added polyethylene glycol (PEG), beginning yellowness index, and final yellowness index after exposure to 3.0 Mrad (MGy) of Cobalt-60 gamma radiation. ASTM Yellowness Index Test D-1925 was used to measure the relative yellowing between the sample containing the additive and the control. The results are shown in Table I where the percent reduction over the control resin is tabulated.

Table I

| EXAMPLES AND COMPARATIVE RUN | PEG E-8000 (ppm) | YI INITIAL | YI FINAL | Δ YI | % REDUCT |
|---|---|---|---|---|---|
| A | 0 | 4.29 | 25.83 | 21.54 | |
| Ex. 1 | 5,000 | 3.49 | 16.85 | 13.36 | 37.9 |
| Ex. 2 | 10,000 | 3.49 | 14.09 | 10.60 | 50.8 |

Examples 3-8 and Comparative Run B

The procedure of Example 1 was repeated with the various polalkyleneyglycols set forth in Table II. The additives were used at the 10,000 parts per million level. The results are set forth in Table II.

Table II

| EXAMPLES AND COMPARATIVE RUN | ADDITIVE | YI INITIAL | YI FINAL | Δ YI | % REDUCT |
|---|---|---|---|---|---|
| B | None | 4.49 | 21.87 | 17.38 | |
| Ex. 3 | E-3350 | 4.21 | 17.44 | 13.23 | 23.9 |
| Ex. 4 | E-4500 | 4.25 | 15.51 | 11.26 | 35.2 |
| Ex. 5 | E-8000 | 3.22 | 14.02 | 10.80 | 37.8 |
| Ex. 6 | P-2000 | 3.25 | 11.10 | 7.85 | 54.8 |
| Ex. 7 | P-4000 | 12.52 | 18.61 | 6.09 | 64.9 |
| Ex. 8 | Voranol 5591 | 22.46 | 31.77 | 9.31 | 46.43 |

In the Examples and Comparative Runs shown in Tables 1 and 2, E-3350, E-4500, and E-8000 are polyethylene glycols having a molecular weight of 3350, 4500, and 8000, respectively. P-2000 and P-4000 are polypropylene glycols having a molecular weight of 2000, and 4000, respectively. Voranol 5591 is a glycerine initiated polypropylene glycol. All of these additives are commercially available from The Dow Chemical Company.

Example 9 and Comparative Run C

The procedure of Example 1 was repeated using 3000 ppm of diethylene glycol dimethyl ether (diglyme) and 3.2 Mrad (MGy) of gamma radiation. The results are set forth in Table III.

Table III

| EXAMPLE AND COMPARATIVE RUN | ADDITIVE | YI INITIAL | YI FINAL | Δ YI | % REDUCT |
|---|---|---|---|---|---|
| C | None | 4.65 | 26.04 | 21.39 | |
| Ex. 9 | Diglyme | 3.86 | 20.90 | 17.04 | 21.3 |

**Claims**

3

1. Use of a polyetherpolyol or the alkyl ethers thereof in an amount of from 500 to 50,000 parts per million for improving the resistance to gamma radiation of a carbonate polymer composition.

2. A process for the production of carbonate polymers having improved resistance to gamma radiation which comprises incorporating into said polymer a gamma radiation resistance improving amount of from 500 - 50,000 parts per million of one or more polyether polyols or the alkyl ethers thereof.

3. The process as set forth in Claim 2 wherein said polyether polyol is (a) derived from the reaction of one or more alkylene oxides with glycols, triols, tetrols, pentols, sugars, or sugar alcohols;
   (b) represented by the formula

   $RO\text{-}CH_2\text{-}C(R_1)H\{O\text{-}CH_2\text{-}C(R_1)H\}_nOR$

   where R is independently hydrogen or an alkyl group of 1 to 4 carbon atoms,
   $R_1$ is hydrogen, methyl or ethyl, and
   n is a number having an average value of 1 to 1000; or
   (c) polypropylene glycol.

4. A carbonate polymer composition with improved resistance to gamma radiation which comprises a carbonate polymer and one or more polyether polyols or the alkyl ethers thereof in a gamma radiation resistance improving amount of from 500 to 50,000 parts per million, whereby said composition does not contain any vinylaromatic polymer component.

5. A carbonate polymer composition with improved resistance to gamma radiation according to claim 4 which the thermoplastic polymer component consists essentially of a carbonate polymer and which comprises one or more polyether polyols or the alkyl ethers thereof in a gamma radiation resistance improving amount of from 500 to 50,000 parts per million.

6. A carbonate polymer composition as set forth in Claim 4 or 5 wherein said polyether polyols are derived from the reaction of one or more alkylene oxides with glycols, triols, tetrols, pentols, sugars, or sugar alcohols.

7. A carbonate polymer composition as set forth in Claim 6 wherein said polyether polyol is polypropylene glycol.

8. A carbonate polymer composition as set forth in Claim 4 or 5 wherein said polyether polyols have the formula

   $RO\text{-}CH_2\text{-}C(R_1)H\{O\text{-}CH_2\text{-}C(R_1)H\}_nOR$

   where R is independently hydrogen or an alkyl group of 1 to 4 carbon atoms,
   $R_1$ is hydrogen, methyl or ethyl, and
   n is a number having an average value of 1 to 1000.

9. A carbonate polymer composition as set forth in Claims 4 through 8 wherein the amount of said polyether polyol is in the range of from 2500 to 15,000 parts per million.

10. A carbonate polymer composition as set forth in Claims 4 through 8 wherein the amount of said polyether polyol is in the range of from 5000 to 10,000 parts per million.

11. A gamma radiated, sterilized article prepared from a carbonate polymer composition, whereby said composition does not contain any vinylaromatic polymer component characterized in that the carbonate polymer comprises one or more polyether polyols or an alkyl ether thereof in a gamma radiation resistance improving amount of from 500 to 50,000 parts per million which article has reduced yellowness.

12. Use of a polyether polyol or an alkyl ether thereof in an amount of from 500 to 50,000 parts per million, in order to improve the resistance to gamma radiation of a carbonate polymer composition whereby said composition does not contain any vinylaromatic polymer component.

13. Use of a polyether polyol or an alkyl ether thereof in an amount of from 500 to 50,000 parts per million in order to improve the gamma radiation resistance of a carbonate polymer composition according to claim 12 in which the thermoplastic polymer component consists of a carbonate polymer.

14. Use of a polyether polyol or an alkyl ether thereof as set forth in claim 12 or 13 wherein said polyether polyol is derived from the reaction of one or more alkylene oxides with glycols, triols, tetrols, pentols, sugars, or sugar alcohols.

15. Use of a polyether polyol or an alkyl ether thereof as set forth in claim 14 wherein said polyether polyol is polypropylene glycol.

16. Use of a polyether polyol or an alkyl ether thereof as set forth in claim 12 or 13 wherein said polyether polyol has the formula

$$RO-CH_2-C(R_1)H\{O-CH_2-C(R_1)H\}_nOR$$

where R is independently hydrogen or an alkyl group of 1 to 4 carbon atoms,
$R_1$ is hydrogen, methyl or ethyl, and
n is a number having an average value of 1 to 1000.

17. Use of a polyether polyol or an alkyl ether thereof as set forth in claims 12 through 16 wherein the amount of said polyether polyol is in the range of from 2500 to 15,000 parts per million.

18. Use of a polyether polyol or an alkyl ether thereof as set forth in claims 12 through 16 wherein the amount of said polyether polyol is in the range of from 5000 to 10,000 parts per million.

**Revendications**

1. Utilisation d'un polyéther-polyol ou de ses éthers d'alkyle, en une proportion valant de 500 à 50 000 parties par million, pour améliorer la résistance d'une composition de polycarbonate au rayonnement gamma.

2. Procédé de production de polycarbonates possédant une résistance améliorée au rayonnement gamma, qui comprend l'incorporation, dans ces polymères, d'une proportion, améliorant la résistance au rayonnement gamma de 500 à 50 000 parties par million d'un ou plusieurs polyéthers-polyols ou éthers alkyliques de ceux-ci.

3. Procédé conforme à la revendication 2, dans lequel ledit polyéther-polyol
(a) provient de la réaction d'un ou plusieurs oxydes d'alkylène avec des glycols, triols, tétrols, pentols, sucres ou alcools de sucre ;
(b) est représenté par la formule :

$$RO-CH_2-C(R_1)H-(-O-CH_2-C(R_1)H-)_n-OR$$

dans laquelle R représente indépendamment un atome d'hydrogène ou un groupe alkyle comportant de 1 à 4 atomes de carbone,
$R_1$ représente un atome d'hydrogène ou un groupe méthyle ou éthyle, et
n est un nombre valant en moyenne 1 à 1000 ; ou
(c) est un polypropylène-glycol.

4. Composition de polycarbonate présentant une résistance améliorée au rayonnement gamma, qui comprend un polycarbonate et un ou plusieurs polyéthers-polyols ou éthers alkyliques de ceux-ci, en une proportion améliorant la résistance au rayonnement gamma et valant de 500 à 50 000 parties par million, ladite composition ne contenant aucun composant polymère de type vinyl-aromatique.

5. Composition de polycarbonate présentant une résistance améliorée au rayonnement gamma, conforme à la revendication 4, dans laquelle le composant polymère thermoplastique consiste en un polycarbonate et qui comprend un ou plusieurs polyéthers-polyols ou éthers alkyliques de ceux-ci, en une proportion améliorant la résistance au rayonnement gamma et valant de 500 à 50 000 parties par million.

6. Composition de polycarbonate conforme à la revendication 4 ou 5, dans laquelle lesdits polyéthers-polyols proviennent de la réaction d'un ou plusieurs oxydes d'alkylène avec des glycols, triols, tétrols, pentols, sucres ou alcools de sucre.

7. Composition de polycarbonate conforme à la revendication 6, dans laquelle ledit polyéther-polyol est un polypropylène-glycol.

8. Composition de polycarbonate conforme à la revendication 4 ou 5, dans laquelle lesdits polyéthers-polyols présentent la formule

$$RO-CH_2-C(R_1)H-(-O-CH_2-C(R_1)H-)_n-OR$$

dans laquelle R représente indépendamment un atome d'hydrogène ou un groupe alkyle comportant de 1 à 4 atomes de carbone,
$R_1$ représente un atome d'hydrogène ou un groupe méthyle ou éthyle, et
n est un nombre valant en moyenne de 1 à 1000.

9. Composition de polycarbonate conforme aux revendications 4 à 8, dans laquelle la proportion dudit polyéther-polyol se situe dans le domaine allant de 2500 à 15 000 parties par million.

10. Composition de polycarbonate conforme aux revendications 4 à 8, dans laquelle la proportion dudit polyéther-polyol se situe dans le domaine allant de 5000 à 10 000 parties par million.

11. Article stérilisé, ayant subi une irradiation par un rayonnement gamma, préparé à partir d'une composition de polycarbonate, cette composition ne contenant aucun composant polymère de type vinyl-aromatique, caractérisé en ce que le polycarbonate contient un ou plusieurs polyétherspolyols ou un éther alkylique de ceux-ci, en une proportion améliorant la résistance au rayonnement gamma et valant de 500 à 50 000 parties par million, lequel article présente un jaunissement réduit.

12. Utilisation d'un polyéther-polyol ou d'un éther alkylique de celui-ci, en une proportion de 500 à 50 000 parties par million, afin d'améliorer la résistance d'une composition de polycarbonate au rayonnement gamma, cette composition ne contenant aucun composant polymère de type vinyl-aromatique.

13. Utilisation d'un polyéther-polyol ou d'un éther alkylique de celui-ci, en une proportion de 500 à 50 000 parties par million, afin d'améliorer la résistance d'une composition de polycarbonate au rayonnement gamma, conformément à la revendication 12, le composant polymère thermoplastique consistant en un polycarbonate.

14. Utilisation d'un polyéther-polyol ou d'un éther alkylique de celui-ci, conforme à la revendication 12 ou 13, ledit polyéther-polyol provenant de la réaction d'un ou plusieurs oxydes d'alkylène avec des glycols, triols, tétrols, pentols, sucre ou alcool de sucre.

15. Utilisation d'un polyéther-polyol ou d'un éther alkylique de celui-ci, conforme à la revendication 14, ledit polyéther-polyol étant un polypropylène-glycol.

16. Utilisation d'un polyéther-polyol ou d'un éther alkylique de celui-ci, conforme à la revendication 12 ou 13, ledit polyéther-polyol présentant la formule :

$$RO-CH_2-C(R_1)H-(-O-CH_2-C(R_1)H-)_n-OR$$

dans laquelle R représente indépendamment un atome d'hydrogène ou un groupe alkyle comportant de 1 à 4 atomes de carbone,
$R_1$ représente un atome d'hydrogène ou un groupe méthyle ou éthyle, et

6

n est un nombre valant en moyenne de 1 à 1000.

17. Utilisation d'un polyéther-polyol ou d'un éther alkylique de celui-ci, conforme aux revendications 12 à 16, dans laquelle la proportion dudit polyéther-polyol se situe dans l'intervalle allant de 2500 à 15 000 parties par million.

18. Utilisation d'un polyéther-polyol ou d'un éther alkylique de celui-ci, conforme aux revendications 12 à 16, dans laquelle la proportion dudit polyéther-polyol se situe dans l'intervalle allant de 5000 à 10 000 parties par million.

**Patentansprüche**

1. Verwendung eines Polyetherpolyols oder der Alkylether davon in einer Menge von 500 bis 50.000 Teilen pro Million zur Verbesserung der Beständigkeit einer Carbonatpolymer-Zusammensetzung gegenüber Gammastrahlung.

2. Verfahren zur Herstellung von Carbonatpolymeren mit verbesserter Beständigkeit gegenüber Gammastrahlung, umfassend das Einbringen einer die Beständigkeit gegen Gammastrahlung verbessernden Menge von 500 bis 50.000 Teilen pro Million eines oder mehrerer Polyetherpolyole oder deren Alkylether in das Polymer.

3. Verfahren nach Anspruch 2, worin das Polyetherpolyol (a) aus der Reaktion eines oder mehrerer Alkylenoxide mit Glykolen, Triolen, Tetrolen, Pentolen, Zuckern oder Zuckeralkoholen stammt,
(b) dargestellt ist durch die Formel

$RO\text{-}CH_2\text{-}C(R_1)H\{O\text{-}CH_2\text{-}C(R_1)H\}_nOR$

worin R unabhängig Wasserstoff oder eine Alkylgruppe mit 1 bis 4 Kohlenstoffatomen ist,
$R_1$ Wasserstoff, Methyl oder Ethyl ist, und
n eine Zahl mit einem Durchschnittswert von 1 bis 1000 ist, oder
(c) Polypropylenglykol ist.

4. Carbonatpolymer-Zusammensetzung mit verbesserter Beständigkeit gegenüber Gammastrahlung, enthaltend ein Carbonatpolymer und ein oder mehrere Polyetherpolyole oder deren Alkylether in einer, die Gammastrahlungsbeständigkeit verbessernden Menge von 500 bis 50.000 Teilen pro Million, wobei die Zusammensetzung keine vinylaromatische Polymerkomponente enthält.

5. Carbonatpolymer-Zusammensetzung mit verbesserter Beständigkeit gegenüber Gammastrahlung nach Anspruch 4, worin die thermoplastische Polymerkomponente aus einem Carbonatpolymer besteht und die ein oder mehrere Polyetherpolyole oder deren Alkylether in einer, die Gammastrahlungsbeständigkeit verbessernden Menge von 500 bis 50.000 Teilen pro Million enthält.

6. Carbonatpolymer-Zusammensetzung nach Anspruch 4 oder 5, worin die Polyetherpolyole aus der Reaktion eines oder mehrerer Alkylenoxide mit Glykolen, Triolen, Tetrolen, Pentolen, Zuckern oder Zuckeralkoholen stammen.

7. Carbonatpolymer-Zusammensetzung nach Anspruch 6, worin das Polyetherpolyol Polypropylenglykol ist.

8. Carbonatpolymer-Zusammensetzung nach Anspruch 4 oder 5, worin die Polyetherpolyole die Formel

$RO\text{-}CH_2\text{-}C(R_1)H\{O\text{-}CH_2\text{-}C(R_1)H\}_nOR$

besitzen,
worin R unabhängig Wasserstoff oder eine Alkylgruppe mit 1 bis 4 Kohlenstoffatomen ist,
$R_1$ Wasserstoff, Methyl oder Ethyl ist, und
n eine Zahl mit einem Durchschnittswert von 1 bis 1000 ist.

7

**9.** Carbonatpolymer-Zusammensetzung nach einem der Ansprüche 4 bis 8, worin die Menge des Polyetherpolyols im Bereich von 2500 bis 15.000 Teilen pro Million ist.

**10.** Carbonatpolymer-Zusammensetzung nach einem der Ansprüche 4 bis 8, worin die Menge des Polyetherpolyols im Bereich von 5000 bis 10.000 Teilen pro Million ist.

**11.** Gammabestrahlter, sterilisierter Gegenstand, hergestellt aus einer Carbonatpolymer-Zusammensetzung, wobei die Zusammensetzung keine vinylaromatische Polymerkomponente enthält, dadurch gekennzeichnet, daß das Carbonatpolymer ein oder mehrere Polyetherpolyole oder einen Alkylether davon in einer, die Gammastrahlungsbeständigkeit verbessernden Menge von 500 bis 50.000 Teilen pro Million enthält, wobei der Gegenstand eine verringerte Gelbfärbung aufweist.

**12.** Verwendung eines Polyetherpolyols oder eines Alkylethers davon in einer Menge von 500 bis 50.000 Teilen pro Million, um die Beständigkeit einer Carbonatpolymer-Zusammensetzung gegenüber Gammastrahlung zu verbessern, wobei die Zusammensetzung keine vinylaromatische Polymerkomponente enthält.

**13.** Verwendung eines Polyetherpolyols oder eines Alkylethers davon nach Anspruch 12 in einer Menge von 500 bis 50.000 Teilen pro Million, um die Beständigkeit einer Carbonatpolymer-Zusammensetzung gegenüber Gammastrahlung zu verbessern, worin die thermoplastische Polymerkomponente aus einem Carbonatpolymer besteht.

**14.** Verwendung eines Polyetherpolyols oder eines Alkylethers davon nach Anspruch 12 oder 13, worin das Polyetherpolyol aus der Reaktion eines oder mehrerer Alkylenoxide mit Glykolen, Triolen, Tetrolen, Pentolen, Zuckern oder Zuckeralkoholen stammt.

**15.** Verwendung eines Polyetherpolyols oder eines Alkylethers davon nach Anspruch 14, worin das Polyetherpolyol Polypropylenglykol ist.

**16.** Verwendung eines Polyetherpolyols oder eines Alkylethers davon nach Anspruch 12 oder 13, worin das Polyetherpolyol die Formel

$$RO-CH_2-C(R_1)H\{O-CH_2-C(R_1)H\}_nOR$$

besitzt,
worin R unabhängig Wasserstoff oder eine Alkylgruppe mit 1 bis 4 Kohlenstoffatomen ist,
$R_1$ Wasserstoff, Methyl oder Ethyl ist, und
n eine Zahl mit einem Durchschnittswert von 1 bis 1000 ist.

**17.** Verwendung eines Polyetherpolyols oder eines Alkylethers davon nach einem der Ansprüche 12 bis 16, worin die Menge des Polyetherpolyols im Bereich von 2500 bis 15.000 Teilen pro Million ist.

**18.** Verwendung eines Polyetherpolyols oder eines Alkylethers davon nach einem der Ansprüche 12 bis 16, worin die Menge des Polyetherpolyols im Bereich von 5000 bis 10.000 Teilen pro Million ist.